# FASCICULE DE BREVET EUROPEEN

(11) **EP 3 959 696 B1**
(45) Date de publication et mention de la délivrance du brevet: **02.04.2025**
(21) Numéro de dépôt: 20730448.6
(22) Date de dépôt: 25.04.2020
(51) Int. Cl.: G08B 6/00, G06F 3/01

(54) **DISPOSITIF À RETOUR HAPTIQUE POURVU DE RAIDISSEURS**
HAPTISCHE RÜCKKOPPLUNGSVORRICHTUNG MIT VERSTEIFUNGEN
HAPTIC FEEDBACK DEVICE PROVIDED WITH STIFFENERS

(30) Priorité: 26.04.2019 FR 1904447
(43) Date de publication de la demande: 02.03.2022
(73) Titulaire: Hap2u, 38400 Saint-Martin-d'Hères (FR)
(72) Inventeur: RUPIN, Matthieu, 38400 Saint Martin D'hères (FR)
(74) Mandataire: Tranvouez, Edern Morgan
(86) Numéro de dépôt international: PCT/FR2020/000153
(87) Numéro de publication internationale: WO 2020/217011

(56) Documents cités:
- EP-A1- 3 287 880
- US-A1- 2017 220 197
- TANINAKA KIYOSHI ET AL: "Analysis of Ultrasound Radiation and Proposal of Design Criteria in Ultrasonic Haptic Display for Practical Applications", 5 June 2018, INTERNATIONAL CONFERENCE ON FINANCIAL CRYPTOGRAPHY AND DATA SECURITY; [LECTURE NOTES IN COMPUTER SCIENCE; LECT.NOTES COMPUTER], SPRINGER, BERLIN, HEIDELBERG, PAGE(S) 376 - 388, ISBN: 978-3-642-17318-9, XP047474206

## Description

### DOMAINE DE L'INVENTION

L'invention concerne les surfaces à retour haptique basées sur le principe de la lubrification ultrasonique.

### ETAT DE LA TECHNIQUE

On connait des dispositifs à retour haptique dans lesquels le milieu de propagation des vibrations est une plaque mince apte à être mise en vibration. Une plaque est dite « mince » lorsqu'elle possède une épaisseur petite devant les deux autres dimensions et devant la longueur d'onde des ondes vibratoires considérées.

De façon connue, la plaque peut être monolithique ou multicouche et de forme rectangulaire. Des actionneurs électromécaniques sont disposés sur la plaque de manière à exciter un mode vibratoire axial, c'est-à-dire dont les nœuds de vibration sont alignés les uns par rapport aux autres selon une ligne parallèle à l'une des arêtes de la plaque.

Dans une plaque dont l'épaisseur n'excède par deux fois la longueur d'onde de la vibration générée par les actionneurs, des ondes de flexion appelées ondes de Lamb A0 (ou des quasi-ondes de Lamb dans le cas d'une plaque multicouche dissymétrique dans l'épaisseur) sont générées et se réfléchissent sur les deux frontières parallèles à la ligne d'alignement des actionneurs.

Lorsque la fréquence d'actionnement est correctement ajustée, un mode stationnaire est excité qui va jouer le rôle d'amplificateur par effet de résonance. Les grandes amplitudes de déplacement ainsi obtenues à des fréquences ultrasoniques entrainent la création d'un coussin d'air comprimé sous la pulpe du doigt d'un utilisateur (effet dit de « squeeze-film » en terminologie anglo-saxonne). Le doigt étant repoussé par la surface, le coefficient de friction est diminué et un effet de retour haptique peut ainsi être obtenu lorsque le doigt est en mouvement. On parle de lubrification ultrasonique.

En revanche, cette approche comporte un inconvénient. En effet, afin d'obtenir un effet de retour haptique uniforme en tout point de la surface, il est crucial que la vibration de la plaque soit la plus uniforme possible. Or, lorsque par exemple le rapport d'aspect (longueur sur largeur) de la surface à actionner se rapproche de 1, il y a alors superposition de deux modes sensiblement à la même fréquence de résonance, l'un selon l'axe X, l'autre selon l'axe Y, ce qui perturbe la déformée modale en créant des interférences. Ce phénomène dégrade l'efficacité de l'actionnement par l'antenne linéique d'actionneurs du fait de l'incompatibilité entre la position des actionneurs et l'allure de la déformée modale. Les actionneurs ne peuvent plus être actionnés par un signal unique, car ils ne vibrent plus en phase.

Cette dégradation se rencontre également avec d'autres formes de support (autres que les formes carrées) : en fait elle se produit dès lors que l'on tente d'obtenir un mode de résonance axial par une ligne d'actionneurs sur un support autre qu'un support rectangulaire, (par exemple des géométries complexes combinant des bords incurvés et des bords droits ou non parallèles).

D'autres problèmes peuvent s'ajouter aux problèmes d'interférence, tels que des problèmes dus à une focalisation des ondes, qui provoquent des surintensités locales, et donc une variabilité de l'amplitude de vibration du support, par exemple sur des supports présentant des concavités, et dans un cas extrême lorsque le support a la forme d'un disque.

On connait par le document EP 3 287 880 A1 un dispositif tactile pourvu d'une plaque mise en vibration à une fréquence ultrasonique par des actionneurs piézoélectriques, et dont la face inférieure présente à certains endroits spécifiques une structure périodique de cannelures ou de réductions d'épaisseur localisées. Cette structure périodique joue le rôle d'un réflecteur de Bragg permettant de confiner les ondes stationnaires à des zones délimitées autour des actionneurs, notamment les zones de la plaque qui doivent être mises en vibration de façon sélective en réponse au contact d'un doigt d'un utilisateur. L'objectif recherché par cette structure est de limiter la consommation d'énergie car seuls les actionneurs situés à proximité des zones touchées par l'utilisateur sont mis en vibration.

La structure périodique décrite dans ce document produit donc des effets opposés à ceux recherchés par la présente invention, qui vise à exciter fortement un mode axial privilégié (unidirectionnel en X ou en Y) sur l'intégralité d'un support à retour haptique de type lubrification ultrasonique, avec une amplitude satisfaisante quelle que soit la forme de ce support, qu'elle soit rectangulaire, carrée, en forme de disque, ou même de forme quelconque.

### BUT DE L'INVENTION

La présente invention a pour but général de proposer une solution pour surmonter les limitations de l'état de la technique, et en particulier pour obtenir un mode axial présentant une vibration unidirectionnelle très homogène sur l'ensemble du support quelles que soient la géométrie et la taille de la surface à actionner, de façon à garantir un actionnement optimal sur l'ensemble du support par une ligne d'actionneurs.

### RESUME DE L'INVENTION

Le principe de l'invention consiste à modifier la structure de la surface du support à actionner pour obtenir une vibration homogène sur toute la surface du support. Le support est initialement isotrope, c'est-à-dire que les ultrasons se propagent à la même vitesse quelle que soit la direction. Il s'agit de rendre le support orthotrope, pour forcer un effet de résonance axial dans une direction particulière du support indépendamment de la géométrie de celui-ci (par exemple un carré, un rectangle, ou même un disque ou une forme quelconque).

Cette anisotropie particulière ou orthotropie de la surface à actionner est obtenue en disposant des éléments raidisseurs unidimensionnels répartis sur l'intégralité d'une face du support, parallèlement les uns aux autres, et ce quelle que soit la géométrie du support. Les actionneurs seront alors disposés selon une ligne parallèle ou perpendiculaire à ces raidisseurs. On obtient ainsi des éléments en relief sur une face du support, qui ne confinent pas les vibrations à des zones du support comme cela est proposé dans le document susvisé, mais qui créent des vitesses de propagation effectives des ondes vibratoires qui diffèrent selon que l'onde se propage parallèlement ou perpendiculairement à ces éléments en relief.

Les actionneurs sont disposés selon une ligne de préférence parallèle aux raidisseurs, mais elle pourrait également être perpendiculaire aux raidisseurs.

L'expérience a prouvé que cette approche est valide quelle que soit la forme de la surface, même si son application pratique concernera davantage les surfaces carrées ou rectangulaires.

L'invention a donc pour objet un dispositif à retour haptique comprenant un support apte à être mis en vibration et dont une première face est revêtue d'au moins une couche incorporant un moyen de détection de la position d'un doigt d'un utilisateur, ledit dispositif comprenant des actionneurs électromécaniques alignés suivant un bord du support ou de ladite couche et susceptibles de mettre ledit support et ladite couche en vibration à une fréquence de résonance ultrasonique, caractérisé en ce que ledit support comporte sur sa seconde face un ensemble de raidisseurs unidimensionnels parallèles les uns aux autres et répartis sur l'ensemble de cette seconde face, lesdits raidisseurs s'étendant en relief par rapport à elle et étant aptes à limiter le fléchissement de la plaque selon un axe perpendiculaire aux raidisseurs et à obtenir un mode de vibration axial et uniforme du support dans lequel tous les ventres sont d'amplitude sensiblement égale.

Les actionneurs électromécaniques sont disposés selon une ligne parallèle ou perpendiculaire aux raidisseurs, de façon à obtenir un mode de vibration axial dont les lignes nodales sont parallèles à l'alignement des actionneurs électromécaniques.

Selon un mode de réalisation, le support est en métal, en verre, en céramique, ou un matériau plastique dans sa phase vitreuse.

Selon un mode de réalisation, ladite première face dudit support est recouverte par une fine couche d'un matériau présentant des pertes viscoélastiques (bois, matière plastique) suffisamment faibles pour ne pas compromettre la résonance ultrasonique dudit support.

Selon un mode de réalisation avantageux, au moins une couche disposée au-dessus du support intègre un dispositif d'affichage, en particulier un écran OLED, dont l'ensemble des couches est solidaire entre elles et apte à transmettre une vibration à une fréquence ultrasonique.

Selon différents modes de réalisation, la fréquence d'actionnement des actionneurs électromécaniques, par exemple des céramiques piézoélectriques, est une fréquence ultrasonique comprise entre 20 kHz et 200 kHz.

Les raidisseurs forment des éléments en relief rectilignes parallèles aménagés sur le support. Ils peuvent être obtenus de diverses manières d'un point de vue industriel. Ainsi ils peuvent notamment être usinés directement dans le support, ou rapportés et collés sur ce même support. Mais le support et ses raidisseurs peuvent aussi être réalisés en une seule opération par injection.

Les raidisseurs, comme leur nom l'indique, rendent plus difficile le fléchissement de la plaque selon un axe perpendiculaire aux raidisseurs. Cela se traduit par une différence de vitesse de propagation de l'onde de flexion dans le cas d'une vibration ultrasonique de la plaque, puisque l'onde de flexion se propagera plus lentement selon un axe perpendiculaire aux raidisseurs. Par conséquent les raidisseurs permettent d'éviter ou de minimiser la formation d'interférences destructrices entre les ondes de flexion issues de l'actionnement de la plaque, puisqu'ils favorisent l'émergence d'un mode axial particulier.

Selon un mode de réalisation optimisé pour une fréquence de résonance de la plaque de 20 kHz, la plaque présente une épaisseur de 2 mm, et les raidisseurs ont une épaisseur de 1 mm et une largeur de 5 mm et sont espacés d'une distance de 5 mm.

Selon un mode de réalisation optimisé pour une fréquence de résonance de la plaque de 200 kHz, la plaque présente une épaisseur de 2 mm, et les raidisseurs ont une épaisseur de 1 mm et une largeur de 1,2 mm et sont espacés d'une distance de 1,8 mm.

### DESCRIPTION DETAILLEE

L'invention sera décrite plus en détail à l'aide des figures, dans lesquelles :
- La figure 1 représente la déformée modale d'une plaque rectangulaire en matériau purement élastique à une fréquence propre ;
- La figure 2 représente la déformée modale d'une plaque carrée en matériau purement élastique correspondant à l'interférence entre deux modes axiaux en x et y qui coexistent à la même fréquence ;
- La figure 3 représente une vue en perspective d'un premier mode de réalisation de l'invention ;
- La figure 4 représente la déformée modale d'une plaque carrée en matériau rigide pourvue de raidisseurs selon l'invention ;
- La figure 5 représente une vue en perspective d'un mode de réalisation particulier de l'invention adapté à une fréquence de vibration ultrasonique de 20 kHz ;
- La figure 6 représente une vue en perspective d'un mode de réalisation particulier de l'invention adapté à une fréquence de vibration ultrasonique de 200 kHz ;
- La figure 7 représente une vue partielle en coupe d'un écran OLED intégrant, conformément à l'invention, un support en matériau rigide apte à être mis en vibration.

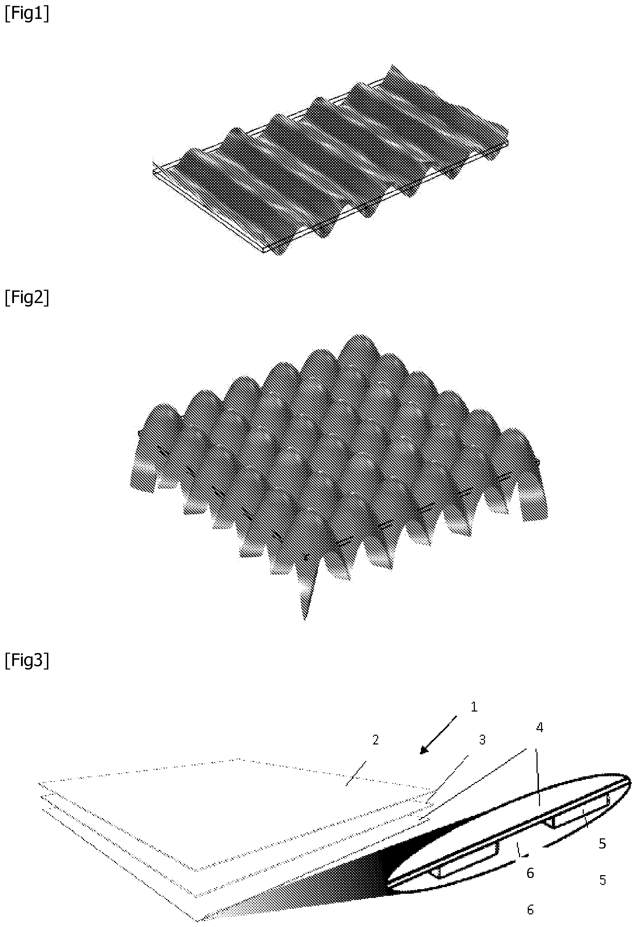

On se réfère à la figure 1. Lorsque le rapport d'aspect (largeur sur longueur) d'une plaque rectangulaire est petit devant 1, un mode de vibration en flexion dit axial, c'est-à-dire présentant des nœuds et des ventres de vibration parallèles à l'une des arêtes de la plaque, peut être obtenu. Ce type de vibration est avantageux car il peut être efficacement obtenu par un ensemble d'actionneurs électromécaniques disposés selon une ligne parallèle aux nœuds de vibration. Dans l'exemple représenté, la plaque présente les dimensions suivantes : 12 cm x 7 cm x 2 mm. Elle est excitée par une force normale appliquée aux quatre coins. La figure 1 correspond à une fréquence d'excitation de 42 kHz.

La figure 2 montre la réponse vibratoire d'une plaque carrée de dimension 12 cm x 12cm x 2 mm avec la même excitation que la plaque rectangulaire de la figure 1. Cette fois, la déformation spatiale n'est plus orientée selon un axe de la plaque mais présente des ventres de vibration circulaires. En réalité cela correspond à la superposition de 2 modes axiaux dits dégénérés car présents à la même fréquence (ici 42318 Hz). Dans ce cas, l'actionnement de ce type de mode de vibration ne peut plus être effectué de manière efficace par des actionneurs agencés selon une ligne.

En figure 3 on a schématisé le principe de la solution selon l'invention : le dispositif 1 comporte plusieurs couches 2, 3, 4. La plaque 4 est une plaque rigide apte à être mise en vibration (par exemple en verre ou en métal), pourvue d'actionneurs piézoélectriques (non représentés). Des raidisseurs 5 en relief ont été ajoutés en sous-face de la plaque 4, à savoir la face de la plaque opposée à celle qui porte les couches supérieures 2,3. Dans l'exemple représenté, les raidisseurs 5 ont une forme parallélépipédique, avec une section transversale rectangulaire, mais d'autres formes de section transversales seraient possibles. Avec les espaces 6 entre les raidisseurs 5, on obtient une structure en relief qui permet de créer une orthotropie dans la vitesse de propagation des ondes de flexion, en particulier celle des ondes de Lamb A0.

Dans l'exemple de réalisation représenté en figure 3, le dispositif 1 possède une structure composite. Il comporte 3 éléments superposés, à savoir par exemple une plaque de verre supérieure 2 (« coverglass » en terminologie anglo-saxonne), un ensemble de couches polymères 3 formant un écran OLED, et une plaque d'aluminium 4 pourvue des raidisseurs 5. L'écran OLED 3 comporte lui-même plusieurs couches, de façon connue en soi. Elles ne sont pas représentées ou détaillées ici.

Dans une variante de réalisation possible, la couche supérieure 2 du dispositif 1 peut éventuellement être constituée par une fine couche d'un matériau non élastique éventuellement opaque (bois, matière plastique) apportant des pertes viscoélastiques suffisamment faibles pour ne pas compromettre la résonance ultrasonique du support.

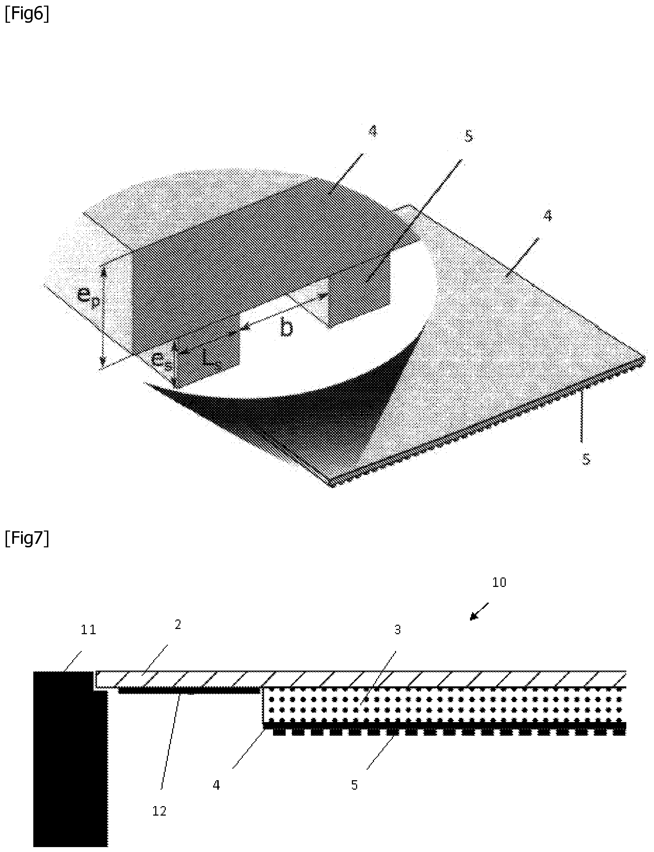

Mais l'invention est particulièrement utile pour un dispositif 10 qui intègre un écran OLED, comme représenté en coupe en figure 7. L'écran OLED 3 est intégré à un châssis 11. Il comporte en face supérieure un verre de protection 2 (« coverglass »). Sous une arête latérale du verre de protection 2 et en alignement avec elle sont collés des actionneurs piézoélectriques 12, permettant de mettre en vibration l'ensemble (2, 3). En variante, les actionneurs 12 pourraient être collés sous la plaque ou support 4 de façon à mettre en vibration l'ensemble constitué par la plaque 4 et les couches 2,3. Les actionneurs 12 sont alimentés par un circuit de commande connu (non représenté). De façon connue, le verre de protection 2 comporte une couche capacitive (non représentée) permettant de rendre le dispositif 10 tactile et de détecter le mouvement des doigts d'un utilisateur. Une plaque métallique 4 est collée contre la face inférieure de l'écran OLED. La face inférieure libre de la plaque métallique 4 est pourvue de raidisseurs 5 en relief. Ils permettent à l'utilisateur qui touche une zone de l'écran sur sa plaque de verre supérieure 2 de ressentir un bien meilleur retour haptique que celui ressenti avec un écran à retour haptique dépourvu de raidisseurs.

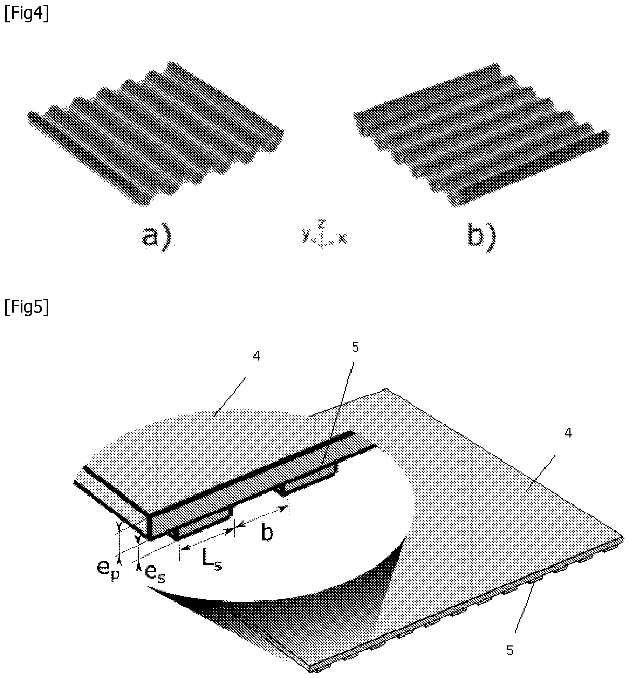

Cela est corroboré par la figure 4 où on a représenté les modes axiaux obtenus après intégration de raidisseurs 5 en sous-face de la plaque 4. Le mode suivant un axe résonne à 43634 Hz tandis que celui situé suivant l'axe perpendiculaire résonne à 53634 Hz. On voit donc que les modes axiaux sont maintenant nettement séparés en fréquence. L'anisotropie apportée par les raidisseurs 5 entraine une différence de vitesse de propagation entre les ondes de flexion qui se propagent selon l'axe x et celles qui se propagent selon l'axe y de la plaque. On constate qu'il est alors possible d'actionner avec une efficacité optimale un mode axial dans une plaque carrée à l'aide d'un ensemble d'actionneurs alignés selon une ligne parallèle à l'une des arêtes de la plaque carrée, c'est-à-dire qu'il est possible d'obtenir de plus grandes amplitudes vibratoires d'une plaque, de façon homogène sur sa surface, avec pourtant une dépense énergétique moindre.

Cela est dû au fait que les raidisseurs rendent plus difficile le fléchissement de la plaque selon un axe perpendiculaire aux raidisseurs, ce qui se traduit, non pas par un confinement localisé des ondes de flexion, mais par une différence de vitesse de propagation de l'onde flexion dans le cas d'une vibration ultrasonique de la plaque.

La plaque 4 sur laquelle sont aménagés les raidisseurs 5 peut elle-même être monolithique ou multicouche. Les raidisseurs 5 ont une section transversale de forme quelconque, mais pour faciliter leur fabrication, cette forme sera de préférence rectangulaire.

En pratique, les raidisseurs 5 peuvent être réalisés par tous moyens utiles, par exemple par fraisage sur une plaque de métal, ou encore en rapportant des raidisseurs qui sont ensuite collés en sous-face de la plaque 4.

Pour garantir une optimisation de l'actionnement, les raidisseurs 5 de la plaque 4 seront positionnés sur des ventres de vibration, et la vibration de l'ensemble sera homogène.

La figure 5 représente un mode de réalisation particulier, correspondant à un point bas de la fréquence vibratoire des actionneurs, à savoir 20 kHz, sur une plaque métallique 4 de 2 mm d'épaisseur (eₚ). Dans ce cas, de bons résultats sont obtenus lorsque les raidisseurs 5 sont dimensionnés comme suit :
- Épaisseur : es = 2 mm
- Largeur : Ls = 5 mm
- Espacement : b = 5 mm
- Longueur : la longueur ou largeur de la plaque

La figure 6 représente un autre mode de réalisation particulier, correspondant à un point haut de la fréquence vibratoire des actionneurs, à savoir 200 kHz, sur une plaque métallique 4 de 2 mm d'épaisseur (eₚ). Dans ce cas, de bons résultats sont obtenus lorsque les raidisseurs 5 sont dimensionnés comme suit :
- Épaisseur : es = 1 mm
- Largeur : Ls = 1,2 mm
- Espacement : b = 1,8 mm
- Longueur : la longueur ou largeur de la plaque

D'autres dimensions optimales des raidisseurs pourront être choisies pour des valeurs de fréquence de résonance comprises entre 20 kHz et 200 kHz.

### AVANTAGES DE L'INVENTION

### L'invention atteint les buts fixés.

En particulier, elle permet grâce à l'utilisation de raidisseurs d'obtenir de plus grandes amplitudes vibratoires d'une plaque, avec pourtant une dépense énergétique moindre.

L'invention s'applique idéalement à tout produit comportant une couche non transparente permettant de masquer les raidisseurs : interrupteurs, pavés tactiles, écrans avec collage optique qui peut être excité en sous face de l'afficheur (type OLED).

Elle permet de garantir une vibration homogène sur la surface d'un matériau rigide apte à être mis en vibration, indépendamment de sa forme, afin d'obtenir un retour haptique identique en tous points de sa surface.

## Revendications

1. - Dispositif (1 ;10) à retour haptique comprenant un support (4) apte à être mis en vibration et dont une première face est revêtue d'au moins une couche (2,3) incorporant un moyen de détection de la position d'un doigt d'un utilisateur, ledit dispositif (1;10) comprenant des actionneurs électromécaniques (12) alignés suivant un bord du support (4) ou d'une couche (2,3) et susceptibles de mettre ledit support (4) et ladite couche (2,3) en vibration à une fréquence de résonance ultrasonique, **caractérisé en ce que** ledit support (4) comporte sur sa seconde face un ensemble de raidisseurs (5) unidimensionnels parallèles les uns aux autres et répartis sur l'ensemble de cette seconde face, lesdits raidisseurs (5) s'étendant en relief par rapport à cette seconde face et étant aptes à limiter le fléchissement de la plaque selon un axe perpendiculaire aux raidisseurs et à obtenir un mode de vibration axial et uniforme du support (4) dans lequel tous les ventres sont d'amplitude sensiblement égale, et **en ce que** les actionneurs électromécaniques (12) sont disposés selon une ligne parallèle ou perpendiculaire aux raidisseurs (5).

2. - Dispositif selon la revendication 1, **caractérisé en ce que** ledit support (4) est en métal, en verre, en céramique, ou en un matériau plastique dans sa phase vitreuse.

3. - Dispositif selon l'une quelconque des revendications précédentes, **caractérisé en ce que** ladite première face dudit support (4) est recouverte par une fine couche d'un matériau présentant des pertes viscoélastiques suffisamment faibles pour ne pas compromettre la résonance ultrasonique dudit support (4).

4. - Dispositif selon l'une quelconque des revendications précédentes, **caractérisé en ce qu'**au moins une couche (2,3) disposée au-dessus dudit support (4) intègre un dispositif d'affichage (3) dont toutes les couches sont solidaires entre elles et aptes à transmettre une vibration à une fréquence ultrasonique.

5. - Dispositif selon la revendication 4, **caractérisé en ce que** ledit dispositif d'affichage (3) est un écran OLED.

6. - Dispositif selon l'une quelconque des revendications précédentes, **caractérisé en ce que** la fréquence d'actionnement des actionneurs électromécaniques (12) est une fréquence ultrasonique comprise entre 20 kHz et 200 kHz.

7. - Dispositif selon l'une quelconque des revendications précédentes, **caractérisé en ce que** les raidisseurs (5) sont obtenus par usinage du support (4) pour laisser subsister des éléments raidisseurs (5) en relief par rapport à ladite seconde face du support (4).

8. - Dispositif selon l'une quelconque des revendications 1 à 6, **caractérisé en ce que** les raidisseurs (5) sont rapportés et collés sur ladite seconde face dudit support (4).

9. - Dispositif selon l'une quelconque des revendications 1 à 6, **caractérisé en ce que** ledit support (4) et ses raidisseurs (5) sont réalisés par injection.

10. - Dispositif selon l'une quelconque des revendications précédentes, optimisé pour une fréquence de résonance de 20 kHz du support (4), **caractérisé en ce que** ledit support (4) est une plaque d'une épaisseur de 2 mm, et **en ce que** les raidisseurs (5) ont une épaisseur de 2 mm en relief par rapport à ladite plaque et une largeur de 5 mm, et sont espacés d'une distance de 5 mm.

11. - Dispositif selon l'une quelconque des revendications 1 à 10, optimisé pour une fréquence de résonance de 200 kHz du support (4), **caractérisé en ce que** ledit support (4) est une plaque présentant une épaisseur de 2 mm, et **en ce que** les raidisseurs (5) ont une épaisseur de 1 mm en relief par rapport à ladite plaque et une largeur de 1,2 mm, et sont espacés d'une distance de 1,8 mm.

## Patentansprüche

1. Vorrichtung (1; 10) mit haptischer Rückmeldung, die einen schwingungsfähigen Träger (4) umfasst und deren erste Seite mit mindestens einer Schicht (2,3) beschichtet ist, die ein Mittel zum Erkennen der Position eines Fingers eines Benutzers einschließt, wobei die Vorrichtung (1; 10) elektromechanische Stellglieder (12) umfasst, die entlang einer Kante des Trägers (4) oder einer Schicht (2,3) ausgerichtet sind und in der Lage sind, den Träger (4) und die Schicht (2,3) mit einer Ultraschallresonanzfrequenz in Schwingung zu versetzen, **dadurch gekennzeichnet, dass** der Träger (4) auf seiner zweiten Seite eine Reihe von eindimensionalen Versteifungen (5) enthält, die parallel zueinander und auf der gesamten zweiten Seite verteilt sind, wobei die Versteifungen (5) sich in Bezug auf die zweite Seite erhaben erstrecken und in der Lage sind, die Durchbiegung der Platte entlang einer Achse senkrecht zu den Versteifungen zu begrenzen und einen axialen und gleichmäßigen Schwingungsmodus des Trägers (4) zu erreichen, in dem alle Bäuche eine im Wesentlichen gleiche Amplitude haben, und dass die elektromechanischen Stellglieder (12) in einer Linie parallel oder senkrecht zu den Versteifungen (5) angeordnet sind.

2. Vorrichtung nach Anspruch 1, **dadurch gekennzeichnet, dass** der Träger (4) in seiner Glasphase aus Metall, Glas, Keramik oder Kunststoff besteht.

3. Vorrichtung nach einem der vorhergehenden Ansprüche, **dadurch gekennzeichnet, dass** die erste Seite des Trägers (4) mit einer dünnen Schicht eines Materials mit ausreichend geringen viskoelastischen Verlusten bedeckt ist, um die Ultraschallresonanz des Trägers (4) nicht zu beeinträchtigen.

4. Vorrichtung nach einem der vorhergehenden Ansprüche, **dadurch gekennzeichnet, dass** in mindestens eine Schicht (2,3), die oberhalb des Trägers (4) angeordnet ist, eine Anzeigevorrichtung (3) integriert ist, deren gesamten Schichten fest miteinander verbunden sind und in der Lage sind, eine Schwingung mit einer Ultraschallfrequenz zu übertragen.

5. Vorrichtung nach Anspruch 4, **dadurch gekennzeichnet, dass** die Anzeigevorrichtung (3) ein OLED-Display ist.

6. Vorrichtung nach einem der vorhergehenden Ansprüche, **dadurch gekennzeichnet, dass** die Betätigungsfrequenz der elektromechanischen Stellglieder (12) eine Ultraschallfrequenz zwischen 20 kHz und 200 kHz ist.

7. Vorrichtung nach einem der vorhergehenden Ansprüche, **dadurch gekennzeichnet, dass** die Versteifungen (5) durch das Bearbeiten des Trägers (4) erhalten werden, um Versteifungselemente (5) bestehen zu lassen, die in Bezug auf die zweite Seite des Trägers (4) erhaben sind.

8. Vorrichtung nach einem der Ansprüche 1 bis 6, **dadurch gekennzeichnet, dass** die Versteifungen (5) auf die zweite Seite des Trägers (4) aufgebracht und verklebt sind.

9. Vorrichtung nach einem der Ansprüche 1 bis 6, **dadurch gekennzeichnet, dass** der Träger (4) und seine Versteifungen (5) durch Spritzguss hergestellt sind.

10. Vorrichtung nach einem der vorhergehenden Ansprüche, die für eine Resonanzfrequenz von 20 kHz des Trägers (4) optimiert ist, **dadurch gekennzeichnet, dass** der Träger (4) eine Platte mit einer Dicke von 2 mm ist, und dass die Versteifungen (5) eine erhabene Dicke von 2 mm in Bezug auf die Platte und eine Breite von 5 mm aufweisen und um einen Abstand von 5 mm beabstandet sind.

11. Vorrichtung nach einem der Ansprüche 1 bis 10, die für eine Resonanzfrequenz von 200 kHz des Trägers (4) optimiert ist, **dadurch gekennzeichnet, dass** der Träger (4) eine Platte ist, die eine Dicke von 2 mm aufweist, und dass die Versteifungen (5) eine erhabene Dicke von 1 mm in Bezug auf die Platte und eine Breite von 1,2 mm aufweisen und um einen Abstand von 1,8 mm beabstandet sind.

## Claims

1. Haptic return device (1; 10) comprising a support (4) capable of being put into vibration and a first face of which is coated with at least one layer (2.3) incorporating a means for detecting the position of a finger of a user, said device (1; 10) comprising electromechanical actuators (12) aligned along an edge of the support (4) or a layer (2.3) and capable of putting said support (4) and said layer (2,3) into vibration at an ultrasonic resonance frequency, **characterised in that** said support (4) comprises on its second face a set of one-dimensional stiffeners (5) parallel to one another and distributed over the entirety of this second face, said stiffeners (5) extending in relief with respect to this second face and being able to limit the deflection of the plate along an axis perpendicular to the stiffeners and to obtain an axial and uniform vibration mode of the support (4) in which all the antinodes are substantially equal in amplitude, and **in that** the electromechanical actuators (12) are arranged along a line parallel or perpendicular to the stiffeners (5).

2. Device according to claim 1, **characterised in that** said support (4) is made of metal, glass, ceramic, or a plastic material in its glass phase.

3. Device according to any one of the preceding claims, **characterised in that** said first face of said support (4) is covered by a thin layer of a material having viscoelastic losses sufficiently low to not compromise the ultrasonic resonance of said support (4).

4. Device according to any one of the preceding claims, **characterised in that** at least one layer (2.3) disposed above said support (4) integrates a display device (3) all the layers of which are integral with each other and capable of transmitting a vibration at an ultrasonic frequency.

5. Device according to claim 4, **characterised in that** said display device (3) is an OLED screen.

6. Device according to any one of the preceding claims, **characterised in that** the frequency of actuation of the electromechanical actuators (12) is an ultrasonic frequency between 20 kHz and 200 kHz.

7. Device according to any one of the preceding claims, **characterised in that** the stiffeners (5) are obtained by machining the support (4) to leave stiffening elements (5) in relief with respect to said second face of the support (4).

8. Device according to any one of claims 1 to 6, **characterised in that** the stiffeners (5) are attached and glued on said second face of said support (4).

9. Device according to any one of claims 1 to 6, **characterised in that** said support (4) and its stiffeners (5) are produced by injection.

10. Device according to any one of the preceding claims, optimised for a resonant frequency of 20 kHz of the support (4), **characterised in that** said support (4) is a plate with a thickness of 2 mm, and **in that** the stiffeners (5) have a thickness of 2 mm in relief with respect to said plate and a width of 5 mm, and are spaced apart by a distance of 5 mm.

11. Device according to any one of claims 1 to 10, optimised for a resonant frequency of 200 kHz of the support (4), **characterised in that** said support (4) is a plate having a thickness of 2 mm, and **in that** the stiffeners (5) have a thickness of 1 mm in relief with respect to said plate and a width of 1.2 mm, and are spaced apart by a distance of 1.8 mm.
